# EUROPEAN PATENT APPLICATION

(11) **EP 3 051 548 A1**
(43) Date of publication of application: **03.08.2016**
(21) Application number: 15158823.3
(22) Date of filing: 12.03.2015
(51) Int. Cl.: H01G 9/20

(54) **Series-type dye-sensitized solar cell module and method of manufacturing the same**

(30) Priority: 29.01.2015 KR 20150014389
(71) Applicant: Sangbo Corporation, Gyeonggi-do 415-866 (KR)
(72) Inventor: Lee, Jeong Gwan, 704-718 Dalseo-gu, Daegu (KR); Lee, Sung Jae, 420-852 Bucheon-si, Gyeonggi-do, (KR); Joung, In Sang, 676-806 Hamyang-gun, Gyeongsangnam-do (KR)
(74) Representative: Stöckeler, Ferdinand

(57) **Abstract**

Disclosed herein is a series-type dye-sensitized solar cell module. The series-type dye-sensitized solar cell module includes a plurality of solar cell unit cells having working electrodes and a counter electrode, a plurality of printed circuit boards having insulation body portions, each having a first current carrying portion which comes into contact with the working electrode of each solar cell unit cell on one surface of each insulation body portion so that an electric current is applied thereto, and a second current carrying portion which comes into contact with the counter electrode of the solar cell unit cells on the other surface of the insulation body portion so that an electric current is applied thereto, and at least one connection terminal portion which electrically connects the first current carrying portion of one printed circuit board to the second current carrying portion of another printed circuit board adjacent thereto.

## Description

### CROSS-REFERENCE(S) TO RELATED APPLICATIONS

This application claims priority to Korean Patent Application No. 10-2015-0014389, filed on January 29, 2015, the disclosure of which is incorporated herein by reference in its entirety.

### BACKGROUND OF THE INVENTION

### Field of the Invention

Exemplary embodiments of the present invention relate to a series-type dye-sensitized solar cell module and a method of manufacturing the same, and more particularly, to a series-type dye-sensitized solar cell module in which a plurality of dye-sensitized solar cell unit cells are connected to each other in series, and a method of manufacturing the same.

### Description of the Related Art

In general, solar cells may be classified into a solar cell made of an inorganic material such as silicon or a compound semiconductor and an organic solar cell using an organic material, according to materials forming the solar cells (the organic solar cell including a dye-sensitized solar cell (DSSC) and an organic D-A solar cell).

The dye-sensitized solar cell is a solar cell which is developed to have high energy efficiency using an organic dye and a nanotechnology. The dye-sensitized solar cell produces electricity using a dye which produces electricity when the dye receives sunlight.

The dye-sensitized solar cell may be manufactured from one-third to one-fifth of costs compared to an existing solar cell since the dye-sensitized solar cell is cheap and has high energy efficiency by means of the cheap organic dye and the nanotechnology. In particular, the dye-sensitized solar cell may be transparent and realize various colors when utilized in glass, and may also be used in such a way to be attached as it is to a glass window of a building and a vehicle window since the dye-sensitized solar cell penetrates visible light. As such, the dye-sensitized solar cell is widely used due to characteristics of being manufactured at a low cost and having high efficiency.

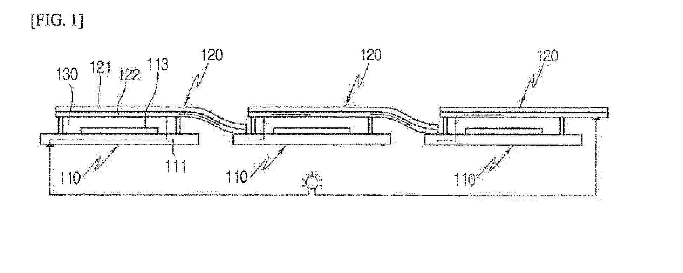

Referring to Fig. 1, a conventional dye-sensitized solar cell, for example, includes a working electrode 110 which has each of conductive substrates 111 spaced apart from each other by a predetermined distance while a nanoparticle oxide 113 and a dye are coated on the conductive substrate 111, a counter electrode 120 having a conductive transparent film for catalyst 122 formed on a transparent substrate 121, and an electrolytic layer 130 having an electrolyte filled between the working electrode 110 and the associated counter electrode 120.

Dye molecules adsorbed onto the nanoparticle oxide absorb sunlight, thereby allowing electrons to be generated.

Many solar cell unit cells have to be interconnected in series or in parallel in order to increase power of the dye-sensitized solar cell. In this case, the series or parallel connection of the unit cells is referred to a module. Unit cells are also interconnected in series or in parallel within a solar cell module, as disclosed in Korean Patent Laid-Open Publication No. 2013-0102940.

The conventional solar cell module shown in Fig. 1 has a structure in which one end of the counter electrode 120 extends outward from the working electrode 110 and the extended end of the counter electrode 120 is overlapped with a working electrode 110 of an adjacent another unit cell so that the unit cells are interconnected in series. Since a process has to be performed in which each unit cell is individually manufactured and then a portion of one unit cell is sequentially overlapped with a portion of the other unit cell such that the unit cells are coupled to each other in the module, it is difficult to uniformly align the unit cells. For this reason, it takes time and effort to align the unit cells, thereby causing productivity of the module to be deteriorated and alignment accuracy of the unit cells to be low.

In addition, since the unit cells are bonded to each other using an adhesive or the like, the unit cells may be decoupled from each other according to adhesive force, thereby causing the module to have low durability.

### SUMMARY OF THE INVENTION

The present invention has been made in view of the above problems of the conventional series-type dye-sensitized solar cell module and method of manufacturing the same, and it is an object of the present invention to provide a series-type dye-sensitized solar cell module and a method of manufacturing the same, in which productivity in a modularization process may be increased durability of the module may be improved through removal of a process of aligning unit cells.

Other objects and advantages of the present invention can be understood by the following description, and become apparent with reference to the embodiments of the present invention. Also, it is obvious to those skilled in the art to which the present invention pertains that the objects and advantages of the present invention can be realized by the means as claimed and combinations thereof.

In accordance with one aspect of the present invention, a series-type dye-sensitized solar cell module includes a plurality of solar cell unit cells having working electrodes which generate electrons by photosensitive dyes and a counter electrode which reduces the electrons by supplying the electrons to the dyes through electrolytes, a plurality of printed circuit boards having insulation body portions formed in the same number as that of the solar cell unit cells, each of the printed circuit boards having a first current carrying portion which comes into contact with the working electrode of each solar cell unit cell on one surface of each insulation body portion so that an electric current is applied to the first current carrying portion, and a second current carrying portion which comes into contact with the counter electrode of the solar cell unit cells on the other surface of the insulation body portion so that an electric current is applied to the second current carrying portion, and at least one connection terminal portion which electrically connects the first current carrying portion of one printed circuit board to the second current carrying portion of another printed circuit board adjacent thereto.

In the series-type dye-sensitized solar cell module, the connection terminal portion may be a diode which blocks a reverse flow of the electric current.

In the series-type dye-sensitized solar cell module, the counter electrode may include one anode substrate having a size capable of covering the entirety of the plurality of solar cell unit cells, a plurality of anode conductive films provided on the anode substrate so as to be spaced apart from each other by a distance between the solar cell unit cells, and anodes for electrolytic reduction catalyst formed on the anode conductive films, respectively.

In the series-type dye-sensitized solar cell module, each of the working electrodes may include a conductive cathode substrate provided one by one for each solar cell unit cell, and a cathode provided on the conductive cathode substrate and made of a porous metal oxide onto which a photosensitive dye is adsorbed.

In the series-type dye-sensitized solar cell module, each of the printed circuit boards may be made of a flexible material.

In the series-type dye-sensitized solar cell module, in each of the printed circuit boards, the first current carrying portion may come into contact with the cathode substrate of the working electrode of each solar cell unit cell so that the electric current is applied to the first current carrying portion, and the second current carrying portion may come into contact with each anode conductive film of the counter electrode of the solar cell unit cells so that the electric current is applied to the second current carrying portion.

In the series-type dye-sensitized solar cell module, the first current carrying portion may be bonded to the cathode substrate of each working electrode by a conductive adhesive, and the second current carrying portion may be bonded to each anode conductive film of the counter electrode by a conductive adhesive.

In the series-type dye-sensitized solar cell module, the cathode substrate may be formed in a thin metal film.

In the series-type dye-sensitized solar cell module, each of the printed circuit boards may further include a third current carrying portion which is provided on the same plane as the second current carrying portion on each insulation body portion while being spaced apart from the second current carrying portion, is electrically connected through a via to the first current carrying portion provided on the other surface of the insulation body portion, and is coupled to the connection terminal portion so as to be electrically connected to the second current carrying portion of the adjacent another solar cell unit cell.

In accordance with another aspect of the present invention, a method of manufacturing a series-type dye-sensitized solar cell module includes manufacturing working electrodes in the same number as that of solar cell unit cells by coating a nanoparticle metal oxide on a conductive cathode substrate and then adsorbing a dye onto the nanoparticle metal oxide, manufacturing a counter electrode by forming anode conductive films in the same number as that of the solar cell unit cells at predetermined intervals on an anode substrate having a width corresponding to the entirety of a solar cell module and respectively forming anodes as reduction catalytic agents on the anode conductive films, bonding the working electrodes and the counter electrode by overlapping them, injecting an electrolyte between the working electrodes and the counter electrode bonded to each other in the bonding the working electrodes and the counter electrode, manufacturing printed circuit boards having insulation body portions of the same number as that of the solar cell unit cells, each of the printed circuit boards having a first current carrying portion formed on one surface of each insulation body portion and a second current carrying portion formed on the other surface of the insulation body portion, connecting the first current carrying portion and the second current carrying portion, which are manufactured in the manufacturing printed circuit boards and formed on the different insulation body portions, in series through a connection terminal portion, and bonding each printed circuit board between tips of each working electrode and the counter electrode, such that the first current carrying portion of the printed circuit board comes into contact with the cathode substrate of the working electrode so that an electric current is applied to the first current carrying portion while the second current carrying portion comes into contact with each anode conductive film of the counter electrode so that an electric current is applied to the second current carrying portion.

In the method of manufacturing a series-type dye-sensitized solar cell module, in the manufacturing working electrodes, after slits are formed on the cathode substrate at intervals of a width between the respective solar cell unit cells, the nanoparticle metal oxide may be coated on the cathode substrate partitioned by the slits, and in the bonding the working electrodes and the counter electrode, after the working electrodes are boned to the counter electrode, a tip of the cathode substrate may be cut such that the cathode substrate is divided in plural numbers on the basis of the slits.

In the method of manufacturing a series-type dye-sensitized solar cell module, in the manufacturing a counter electrode, collector electrodes made of silver may be formed on the anode conductive films independently of the anodes.

It is to be understood that both the foregoing general description and the following detailed description of the present invention are exemplary and explanatory and are intended to provide further explanation of the invention as claimed.

### BRIEF DESCRIPTION OF THE DRAWINGS

The above and other objects, features and other advantages of the present invention will be more clearly understood from the following detailed description taken in conjunction with the accompanying drawings, in which:
Fig. 1 is a cross-sectional view schematically illustrating a series-type dye-sensitized solar cell module according to the related art;
Fig. 2 is a perspective view illustrating a series-type dye-sensitized solar cell module according to an embodiment of the present invention;
Fig. 3 is a cross-sectional view illustrating a printed circuit board shown in Fig. 2; and
Fig. 4 is a conceptual view illustrating a method of manufacturing the series-type dye-sensitized solar cell module shown in Fig. 3.

### DESCRIPTION OF SPECIFIC EMBODIMENTS

Exemplary embodiments of the present invention will be described below in more detail with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art. Throughout the disclosure, like reference numerals refer to like parts throughout the various figures and embodiments of the present invention. The drawings are not necessarily to scale and in some instances, proportions may have been exaggerated in order to clearly illustrate features of the embodiments.

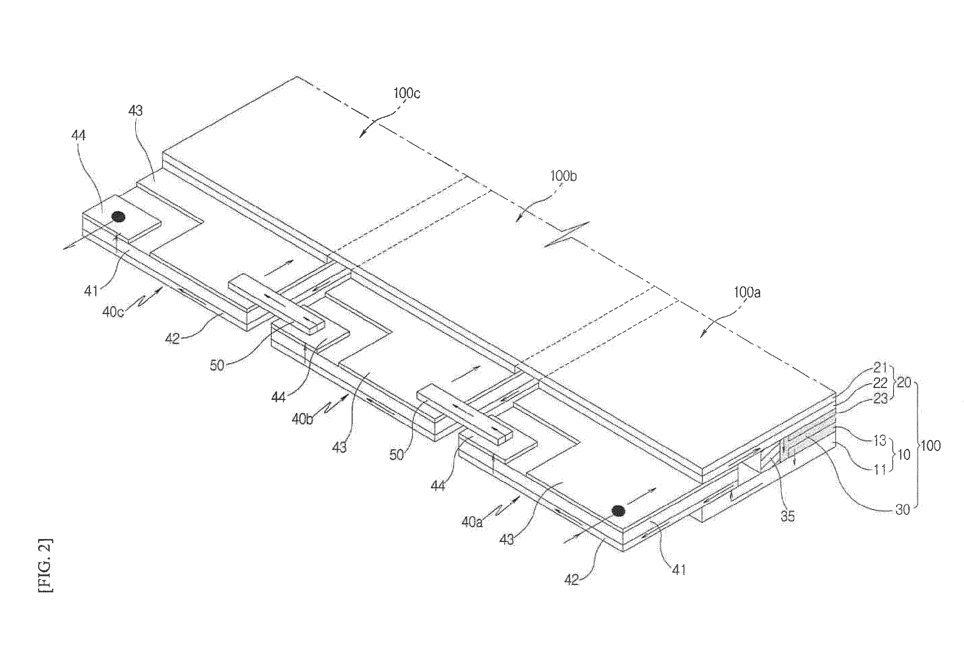

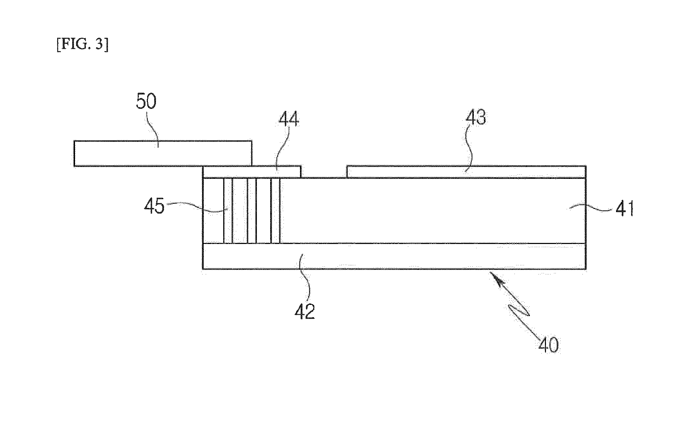

Referring to Figs. 2 and 3, a series-type dye-sensitized solar cell module according to an embodiment of the present invention includes a plurality of solar cell unit cells 100 having working electrodes 10 which generate electrons by photosensitive dyes and a counter electrode 20 which reduces the electrons by supplying the electrons to the dyes through electrolytes 30, a plurality of printed circuit boards 40, each having a first current carrying portion 42 which comes into contact with the working electrode 10 of each of the solar cell unit cells 100 and a second current carrying portion 43 which comes into contact with the counter electrode 20, and connection terminal portions 50, each of which electrically connects the first current carrying portion 42 of one printed circuit board 40 to the second current carrying portion of the adjacent another printed circuit board 40.

The solar cell unit cells 100 include the working electrodes 10, the electrolytes 30, and the counter electrode 20.

Each of the working electrodes 10 includes a conductive cathode substrate 11 and a cathode 13 made of a porous metal oxide onto which the photosensitive dye is adsorbed. The conductive cathode substrate 11 is provided one by one for each solar cell unit cell 100. In the embodiment, the cathode substrate 11 is formed in a thin metal film having conductivity.

Here, the cathode substrate 11 may be configured of a transparent film and a conductive transparent film. That is, the working electrode 10 may also have a cathode conductive film formed on the transparent film in the same manner that the counter electrode 20 has anode conductive films 22 formed on an anode substrate 21. In this case, the cathode conductive film comes into contact with the first current carrying portion 42 of the printed circuit board 40 so that an electric current is applied to the cathode conductive film.

The cathode 13 is configured by adsorbing the photosensitive dye onto the porous metal oxide made of nanoparticles such as TiO₂, SnO₂, ZnO, and Nb₂O₅. The cathode 13 is provided on the cathode substrate 11 to transfer electrons generated by the dye to the cathode substrate 11 through the metal oxide.

The counter electrode 20 includes one anode substrate 21 having a size capable of covering the entirety of the plurality of solar cell unit cells 100a, 100b, and 100c, a plurality of anode conductive films 22 which are provided on the anode substrate 21 to be spaced apart from each other by a distance between the solar cell unit cells 100a, 100b, and 100c, and anodes for electrolytic reduction catalyst 23 which are respectively formed on the anode conductive films 22.

The anode substrate 21 has a size capable of covering the entirety of the plurality of solar cell unit cells 100a, 100b, and 100c. The anode substrate 21 has a size capable of covering the entirety of the plurality of solar cell unit cells 100a, 100b, and 100c instead of being provided one by one for each solar cell unit cell 100, and is formed as one body. The plurality of solar cell unit cells 100a, 100b, and 100c share one large anode substrate 21.

When the plurality of solar cell unit cells 100a, 100b, and 100c use one anode substrate 21 together as described above, a position between the solar cell unit cells 100a, 100b, and 100c is uniformly adjusted and thus the solar cell module having uniform arrangement may be easily manufactured. That is, it is difficult to uniformly adjust and couple conventional solar cell unit cells since the solar cell unit cells are respectively manufacture and then bonded to each other. However, the positions of the respective solar cell unit cells 100a, 100b, and 100c are set at one anode substrate 21 in the embodiment. Accordingly, there is no need to intentionally adjust arrangement between the solar cell unit cells 100 and thus the printed circuit boards 40 may be uniformly coupled in place.

Each of the anode conductive films 22 is formed in a transparent conductive film made of ITO, and each of the anodes 23 is made of platinum (Pt), carbon nanotube, nanocarbon, or the like.

Meanwhile, since the anode substrate 21 has high resistance, a collector electrode made of silver (Ag) is typically coated on the anode conductive film 22, independently of the anode conductive film 22.

Each of the printed circuit boards 40 includes an insulation body portion 41, a first current carrying portion 42 which comes into contact with one surface of the insulation body portion 41 and the working electrode 10 of the associated solar cell unit cell 100 so that an electric current is applied to the first current carrying portion 42, a second current carrying portion 43 which comes into contact with the other surface of the insulation body portion 41 and the counter electrode 20 of the solar cell unit cell 100 so that an electric current is applied to the second current carrying portion 43, and a third current carrying portion 44 connected with the associated connection terminal portion 50.

The insulation body portion 41 is an insulator, and each of the first and second current carrying portions 42 and 43 is an electric conductor which is formed in a conductive polymer film or a thin metal film.

The first current carrying portion 42 comes into contact with the cathode substrate 11 of the working electrode 10 of each solar cell unit cell 100 so that an electric current is applied to the first current carrying portion 42. Thus, electrons generated by the working electrode 10 may move from the cathode substrate 11 to the first current carrying portion 42.

The second current carrying portion 43 comes into contact with each anode conductive film 22 of the counter electrode 20 of the solar cell unit cell 100 so that an electric current is applied to the second current carrying portion 43. Thus, the electrons transferred to the second current carrying portion 43 may move to the anode conductive film 22 of the counter electrode 20 and then be reduced as an electrolyte.

The first current carrying portion 42 is bonded and coupled to the cathode substrate 11 of the working electrode 10 with a conductive adhesive, and the second current carrying portion 43 is bonded and coupled to the anode conductive film 22 of the counter electrode 20 with a conductive adhesive.

The first current carrying portion 42 is formed on a back surface of the insulation body portion 41, and the second current carrying portion 43 is formed on an upper surface of the insulation body portion 41. Accordingly, an electric current is not applied to the first and second current carrying portions 42 and 43 by the insulation body portion 41 in one printed circuit board 40. The first current carrying portion 42 of one printed circuit board 40 is electrically connected to the second current carrying portion 43 of the adjacent another printed circuit board 40 through the connection terminal portion 50.

The third current carrying portion 44 is located on the same plane as the second current carrying portion 43 on the insulation body portion 41, that is, is provided on the upper surface of the insulation body portion 41 while being spaced apart from the second current carrying portion 43. The third current carrying portion 44 is electrically connected to the first current carrying portion 42 provided on the back surface of the insulation body portion 41 through vias 45. The vias 45 are provided by penetrating the insulation body portion 41 so that the first current carrying portion 42 is electrically connected to the third current carrying portion 44. The third current carrying portion 44 is electrically connected to the second current carrying portion 43 of the adjacent another solar cell unit cell 100 which is connected to one end of the connection terminal portion 50.

Since the third current carrying portion 44 is provided on the same plane as the second current carrying portion 43, both ends of the connection terminal portion 50 may be installed at the same height. Thus, both ends of the connection terminal portion 50 may be easily installed at both printed circuit boards 40 without bending the connection terminal portion 50 or adding a separate lead wire.

Here, the connection terminal portion 50 may directly connect the first current carrying portion 42 to the second current carrying portion 43 without provision of the third current carrying portion 44 and the vias 45. The first and second current carrying portions 42 and 43 have the same height difference as a thickness of the insulation body portion 41. Thus, the first current carrying portion 42 may be electrically connected to the second current carrying portion 43 by bending the connection terminal portion 50 or adding the separate lead wire (not shown).

The printed circuit board 40 in the embodiment is an F-PCB (Flexible Printed Circuit Board) made of a flexible material.

The connection terminal portion 50 is a diode which blocks a reverse flow of an electric current. Both ends of the connection terminal portion 50 may be coupled to the respective second current carrying portions 43 and third current carrying portion 44 of the different printed circuit boards 40. The connection terminal portion 50 allows electrons to move from one printed circuit board 40 to another printed circuit board 40, but does not allow the electrons to move in the reverse direction. Accordingly, the plurality of solar cell unit cells 100a, 100b, and 100c may be interconnected in series such that electrons flow in one direction.

Hereinafter, a current flow according to series connection will be described with reference to Fig. 2.

First, electrons generated by the working electrode 10 of the solar cell unit cell 100a located at the foremost position in the drawing, namely, by the dye of the cathode 13 move to the cathode substrate 11 through the nanoparticle metal oxide. The electrons moved to the cathode substrate 11 in the solar cell unit cell 100a move to the first current carrying portion 42 of the printed circuit board 40a, move to the third current carrying portion 44 through the vias 45, and then move to the second current carrying portion 43 of the adjacent another printed circuit board 40b through the connection terminal portion 50.

The electrons moved to the second current carrying portion 43 of the adjacent another printed circuit board 40b move to the anode conductive film 22 of the solar cell unit cell 100b located at an intermediate position and are then transferred to the cathode 13 through the anode 23 and the electrolyte 30.

The electrons transferred to the cathode 13 of the intermediate solar cell unit cell 100b sequentially pass through the first current carrying portion 42, the vias 45, the third current carrying portion 44, and the connection terminal portion 50 of the printed circuit board 40b together with electrons generated by the dye of the solar cell unit cell 100b, and are then transferred to the second current carrying portion 43 of the printed circuit board 40c located at the last position. Subsequently, the electrons move to the cathode 13 through the anode 23 and the electrolyte 30 of the last solar cell unit cell 100c.

Electrons generated by the dye of the last solar cell unit cell 100c move to the third current carrying portion 44 via the first current carrying portion 42 and the vias 45 of the printed circuit board 40c together with the electrons generated by the dyes of the other solar cell unit cells 100a and 100b, and are then transferred to an electric device (not shown) through a lead wire (not shown) connected to the third current carrying portion 44.

As described above, all of the electrons generated by the dyes of the respective solar cell unit cells 100a, 100b, and 100c move in one direction through the plurality of printed circuit boards 40a, 40b, and 40c, thereby allowing the plurality of solar cell unit cells 100a, 100b, and 100c to be interconnected in series.

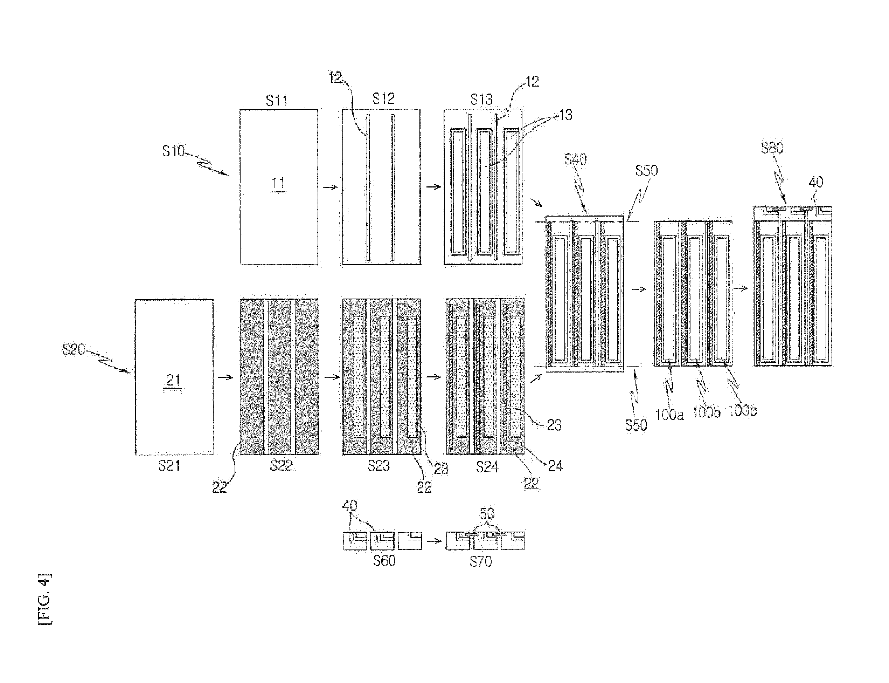

A method of manufacturing a series-type dye-sensitized solar cell module according to an embodiment of the present invention will be described with reference to Figs. 2 to 4.

First, a working electrode 10, a counter electrode 20, and a printed circuit board 40 are each manufactured of a flexible material such as a polymer film or a thin metal film.

In a working electrode manufacturing step (S10), a conductive cathode substrate 11, which has a size corresponding to the entirety of a solar cell module and is made of a thin metal film, is first prepared (S11). Slits 12 are formed on the conductive cathode substrate 11 at intervals of a width of each solar cell unit cell (S12). Cathodes 13 are manufactured in the same number as that of the solar cell unit cells 100 by coating a nanoparticle metal oxide on the cathode substrate 11 partitioned by the slits 12 and then adsorbing a dye onto the nanoparticle metal oxide (S13). In this case, the cathode substrate 11 is in a state in which the cathode substrate 11 is partitioned in plural numbers by the slits 12 but is not separated.

In a counter electrode manufacturing step (S20), an anode substrate 21 having a width corresponding to the entirety of the solar cell module is first prepared (S21). Anode conductive films 22 are formed on the anode substrate 21 at predetermined intervals in the same number as that of the solar cell unit cells 100 (S22). The anode conductive films 22 are formed by etching ITO on the anode substrate 21. Anodes 23 are respectively formed by coating reduction catalytic agents such as platinum (Pt), carbon nanotube (CNT), and nanocarbon on the respective anode conductive films 22 (S23).

After the anodes 23 are formed, collector electrodes 24 made of silver (Ag) are formed on the anode conductive films 22 independently of the anodes 23 (S24).

When all of the working electrode 10 and the counter electrode 20 are manufactured, the working electrode 10 and the counter electrode 20 are overlapped with and bonded to each other (S40). After the working electrode 10 and the counter electrode 20 are bonded in the bonding step (S40), an electrolyte 30 is injected between the working electrode 10 and the counter electrode 20. Here, a partition wall 35 which surrounds the cathode 13 or the anode 23 has to be formed so as to obtain a sealed space into which the electrolyte is injected in the step of manufacturing the working electrode 10 and the counter electrode 20. Since this process is equal to a process of manufacturing a typical dye-sensitized solar cell, a description thereof will be omitted.

After the working electrode 10 and the counter electrode 20 are bonded in the bonding step (S40), the cathode substrate 11 is divided in plural numbers on the basis of the slits 12 by cutting a tip of the cathode substrate 11 (S50). This enables an electric current to be not applied between the cathode substrates 11 forming the respective solar cell unit cells 100.

Meanwhile, in a printed circuit board manufacturing step (S60), insulation body portions 41 are first provided in the same number as that of the solar cell unit cells 100. A first current carrying portion 42 made of a conductive material is formed on an upper surface of each insulation body portion 41, and a second current carrying portion 43 made of a conductive material is formed on a back surface of each insulation body portion 41.

When a plurality of printed circuit boards 40 are manufacture, the printed circuit boards 40 are interconnected by connection terminal portions 50 (S70). In the series connection step (S70), the respective first current carrying portions 42 and second current carrying portion 43 formed on the insulation body portions 41 of the different printed circuit boards 40 are interconnected by the connection terminal portions 50 so that an electric current is applied to the first current carrying portions 42 and the second current carrying portion 43. In this case, vias 45 and a third current carrying portion 44 are installed at each insulation body portion 41, and one end of each connection terminal portion 50 is coupled to the associated third current carrying portion 44.

When the plurality of printed circuit boards 40 are interconnected in series through the connection terminal portions 50, the printed circuit boards 40 are coupled to the respective solar cell unit cells 100 (S80).

In the printed circuit board coupling step (S80), the printed circuit boards 40 are inserted into an opened gap between tips of the working electrodes 10 and counter electrode 20 of the solar cell unit cells 100. In this case, after the first current carrying portion 42 of each printed circuit board 40 comes into contact with the cathode substrate 11 of each working electrode 10 and the second current carrying portion 43 comes into contact with each anode conductive film 22 of the counter electrode 20, the first and second current carrying portions 42 and 43 are bonded to each other with an adhesive.

Here, the series connection step (S50) and the printed circuit board coupling step (S80) may be performed regardless of an order. That is, the connection terminal portions 50 may be coupled to the printed circuit boards 40 in a state in which the printed circuit boards 40 are coupled to the solar cell unit cells 100 so as to be fixed. On the contrary, the printed circuit boards 40 may be interconnected by the connection terminal portions 50 and then be simultaneously coupled to the solar cell unit cells 100.

As is apparent from the above description, in accordance with a series-type dye-sensitized solar cell module and a method of manufacturing the same according to embodiments of the present invention, it may be possible to remove a process of aligning unit cells by manufacturing the unit cells in such a manner that the unit cells are not fully separated from each other and portions thereof are shared. Thus, productivity in a modularization process may be increased and durability of the module may be improved.

While the present invention has been described with respect to the specific embodiments, it will be apparent to those skilled in the art that various changes and modifications may be made without departing from the spirit and scope of the invention as defined in the following claims.

## Claims

1. A series-type dye-sensitized solar cell module comprising:
a plurality of solar cell unit cells having working electrodes which generate electrons by photosensitive dyes and a counter electrode which reduces the electrons by supplying the electrons to the dyes through electrolytes;
a plurality of printed circuit boards having insulation body portions formed in the same number as that of the solar cell unit cells, each of the printed circuit boards having a first current carrying portion which comes into contact with the working electrode of each solar cell unit cell on one surface of each insulation body portion so that an electric current is applied to the first current carrying portion, and a second current carrying portion which comes into contact with the counter electrode of the solar cell unit cells on the other surface of the insulation body portion so that an electric current is applied to the second current carrying portion; and
at least one connection terminal portion which electrically connects the first current carrying portion of one printed circuit board to the second current carrying portion of another printed circuit board adjacent thereto.

2. The series-type dye-sensitized solar cell module according to claim 1, wherein the connection terminal portion is a diode which blocks a reverse flow of the electric current.

3. The series-type dye-sensitized solar cell module according to claim 1, wherein the counter electrode comprises:
one anode substrate having a size capable of covering the entirety of the plurality of solar cell unit cells;
a plurality of anode conductive films provided on the anode substrate so as to be spaced apart from each other by a distance between the solar cell unit cells; and
anodes for electrolytic reduction catalyst formed on the anode conductive films, respectively.

4. The series-type dye-sensitized solar cell module according to claim 3, wherein each of the working electrodes comprises:
a conductive cathode substrate provided one by one for each solar cell unit cell; and
a cathode provided on the conductive cathode substrate and made of a porous metal oxide onto which a photosensitive dye is adsorbed.

5. The series-type dye-sensitized solar cell module according to claim 4, wherein, in each of the printed circuit boards, the first current carrying portion comes into contact with the cathode substrate of the working electrode of each solar cell unit cell so that the electric current is applied to the first current carrying portion, and the second current carrying portion comes into contact with each anode conductive film of the counter electrode of the solar cell unit cells so that the electric current is applied to the second current carrying portion.

6. The series-type dye-sensitized solar cell module according to claim 5, wherein:
the first current carrying portion is bonded to the cathode substrate of each working electrode by a conductive adhesive; and
the second current carrying portion is bonded to each anode conductive film of the counter electrode by a conductive adhesive.

7. The series-type dye-sensitized solar cell module according to claim 4, wherein the cathode substrate is formed in a thin metal film.

8. The series-type dye-sensitized solar cell module according to claim 1, wherein each of the printed circuit boards further comprises a third current carrying portion which is provided on the same plane as the second current carrying portion on each insulation body portion while being spaced apart from the second current carrying portion, is electrically connected through a via to the first current carrying portion provided on the other surface of the insulation body portion, and is coupled to the connection terminal portion so as to be electrically connected to the second current carrying portion of the adjacent another solar cell unit cell.

9. The series-type dye-sensitized solar cell module according to claim 1, wherein each of the printed circuit boards is made of a flexible material.

10. A method of manufacturing a series-type dye-sensitized solar cell module, comprising:
manufacturing working electrodes in the same number as that of solar cell unit cells by coating a nanoparticle metal oxide on a conductive cathode substrate and then adsorbing a dye onto the nanoparticle metal oxide;
manufacturing a counter electrode by forming anode conductive films in the same number as that of the solar cell unit cells at predetermined intervals on an anode substrate having a width corresponding to the entirety of a solar cell module and respectively forming anodes as reduction catalytic agents on the anode conductive films;
bonding the working electrodes and the counter electrode by overlapping them such that an electrolyte is injected therebetween;
manufacturing printed circuit boards having insulation body portions of the same number as that of the solar cell unit cells, each of the printed circuit boards having a first current carrying portion formed on one surface of each insulation body portion and a second current carrying portion formed on the other surface of the insulation body portion;
connecting the first current carrying portion and the second current carrying portion, which are manufactured in the manufacturing printed circuit boards and formed on the different insulation body portions, in series through a connection terminal portion; and
bonding each printed circuit board between tips of each working electrode and the counter electrode, such that the first current carrying portion of the printed circuit board comes into contact with the cathode substrate of the working electrode so that an electric current is applied to the first current carrying portion while the second current carrying portion comes into contact with each anode conductive film of the counter electrode so that an electric current is applied to the second current carrying portion.

11. The method according to claim 10, wherein:
in the manufacturing working electrodes, after slits are formed on the cathode substrate at intervals of a width between the respective solar cell unit cells, the nanoparticle metal oxide is coated on the cathode substrate partitioned by the slits; and
in the bonding the working electrodes and the counter electrode, after the working electrodes are boned to the counter electrode, a tip of the cathode substrate is cut such that the cathode substrate is divided in plural numbers on the basis of the slits.

12. The method according to claim 10, wherein, in the manufacturing a counter electrode, collector electrodes made of silver are formed on the anode conductive films independently of the anodes.
